(19) Europäisches Patentamt
European Patent Office
Office européen des brevets

(11) **EP 1 850 139 A1**

(12) **EUROPEAN PATENT APPLICATION**

(43) Date of publication:
**31.10.2007 Bulletin 2007/44**

(51) Int Cl.:
***G01R 31/26*** (2006.01)

(21) Application number: **06013961.5**

(22) Date of filing: **05.07.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **18.04.2006 CN 200610076725**

(71) Applicant: **Macroblock Inc.**
**Hsin-Chu city (TW)**

(72) Inventor: **Wang, Hung-Tsung**
**Hsin-Chu City (TW)**

(74) Representative: **Jehle, Volker Armin et al**
**Bosch, Graf v. Stosch, Jehle**
**Patentanwalt GmbH**
**Flüggenstrasse 13**
**80639 München (DE)**

(54) **Method and apparatus for silent detection**

(57) The present invention discloses a method and an apparatus for silent current detection. By measuring voltage of a control output of a driver control circuit for driving an application device, leakage current of the driver control circuit can be detected. If the application device has an energy bandgap, short or open states of the device can further be detected. These detections are achieved, no matter whether the application device is driven or not.

FIG. 1

## Description

### FIELD OF THE INVENTION

The present invention relates to a method and an apparatus for silent current detection, which can be applied to an application device driven by a driver control circuit, and particularly to an application device with an energy bandgap.

### BACKGROUND OF THE INVENTION

Semiconductor devices such as LEDs (Light Emitting Diodes) are widely applied to illumination and directors. Traditionally, the only way to judge normality or abnormality of these devices is to turn them on. This method may be acceptable for general devices but dangerous for traffic signs or vehicle lighting which should not be turned on arbitrarily. So far, real-time detection for some devices is still unavailable, nevertheless important.

To overcome the above problem, the present invention provides a method and an apparatus for silent current detection (i.e., zero current detection).

### SUMMARY OF THE INVENTION

The present invention provides a method and an apparatus for silent current detection (i.e., zero current detection) to judge states of an application device and a driver control circuit thereof, no matter whether the device is driven or not.

In a normal condition, the application device has two contacts respectively connected to a voltage source and a control output of a driver control circuit. The voltage source can provide the application device a proper voltage, and the driver control circuit can drive the application device. The silent current detection can be achieved by measuring voltage of the control output of the driver control circuit, no matter whether the application device is driven or not.

### BRIEF DESCRIPTION OF THE DRAWINGS

FIG. 1 shows an embodiment of the present invention.
FIG. 2 shows an equivalent circuit of the drain and the P-type substrate.
FIG. 3 indicates relationship of the bandgap voltage and electrical parameters of the LED.
FIG. 4 indicates relationships of the voltage settings for short and open detections.
FIG. 5 shows another embodiment of the present invention.

## DETAILED DESCRIPTION

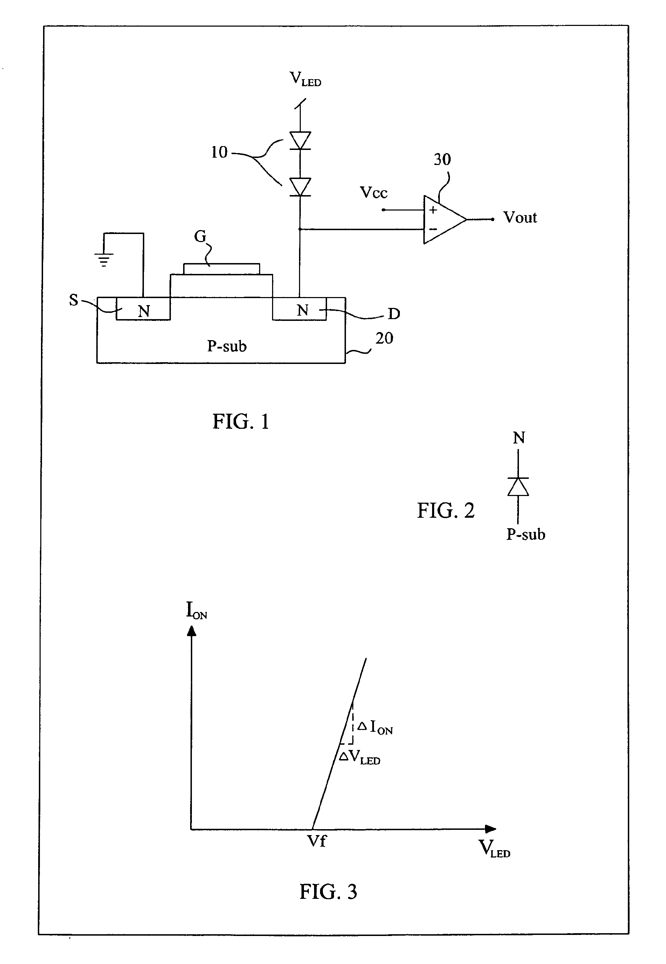

FIG. 1 shows an embodiment of the apparatus for silent current detection, which includes an LED unit (10) having an anode contact and a cathode contact, and a driver control circuit including an NMOS transistor (20). The LED unit (10) may include one LED or serial LEDs. The NMOS transistor (20) has a P-type substrate (P-sub), a drain (D) defined as a control output of the driver control circuit, a gate (G) for receiving control signals, and a source (S) grounding. In a normal condition, a voltage source is connected to the cathode contact of the LED unit (10) to provide a stable voltage ($V_{LED}$). The drain of the NMOS transistor (20) is connected to the anode contact of the LED unit (10) for driving the LEDs and controlling brightness thereof. The drain and the P-type substrate behave as "an inverse diode", and FIG. 2 shows an equivalent circuit thereof. A comparator (30) provided in this embodiment has a positive electrode supplied with a reference voltage ($V_{CC}$) and a negative electrode connected to the control output of the driver control circuit. The comparator (30) compares voltages of the positive electrode and the negative electrode, and then outputs a signal ($V_{out}$).

For one LED, relationship between voltage ($V_{LED}$), forward conduction current ($I_{ON}$) and forward conduction resistance ($R_{ON}$) is:

$$R_{ON} = \Delta V_{LED} \div \Delta I_{ON}$$

wherein $R_{ON}$ is preferably about 10 ohm.

In the present invention, a bandgap voltage existing in a semiconductor device with an energy bandgap is utilized. FIG. 3 indicates relationship of the bandgap voltage ($V_f$) and these parameters.

Accordingly, if electrical connection of the LED unit (10) in the circuit is normal, the control output of the driver control circuit (or the negative electrode of the comparator) in FIG. 1 has a voltage ($V_d$) as follows:

$$V_d = V_{LED} - (n \times V_f + (R_{ON} \times I_{ON}))$$

wherein $V_{LED}$ is preferably defined as 5v according to a general industrial specification; n is an amount of LEDs in the LED unit; and $V_f$ is the bandgap voltage of one LED. Since $V_f$ is a constant, $V_d$ will be a constant when the LED is not driven or lit. That is, $I_{ON}=0$, and

$$V_d \approx V_{LED} - (n \times V_f).$$

However, if electrical connection of the LED unit (10) in the circuit is "open", the driver control circuit couldn't remain the voltage level as normal. Consequently, voltage at the control output will reduce to about zero as low current inversely flows from the drain to the P-type substrate. Therefore, the "open" state can be detected when voltage of the control output is lower than $(V_{LED}-n \times V_f)$.

On the other hand, if the LED unit (10) is "short", then voltage of the control output of the driver control circuit will increase and be higher than $(V_{LED}-V_f)$.

Accordingly, in this embodiment:

a. in case of three serial red LEDs ($V_f$=1.4v), reference voltage will be 3.6v (=5-1.4) for "short-circuit-detection" and 0.8V (=5-3x1.4) for "open-circuit-detection";
b. in case of two serial blue LEDs ($V_f$=2.3v), reference voltage will be 2.7v (=5-2.3) for "short-circuit-detection" and 0.4v (=5-2x2.3) for "open-circuit-detection";
c. in case of two serial green LEDs ($V_f$=1.7v), reference voltage will be 3.3v (=5-1.7) for "short-circuit-detection" and 1.6v (=5-2$\times$1.7) for "open-circuit-detection";
d. in case of a channel including the above serial LEDs in a, b and c, reference voltage may be slightly lower than the minimum among the above reference voltages for "open-circuit-detection", i.e., about 0.3v; and slightly higher than the maximum among the above reference voltages for "short-circuit-detection", i.e., about 3.7v.

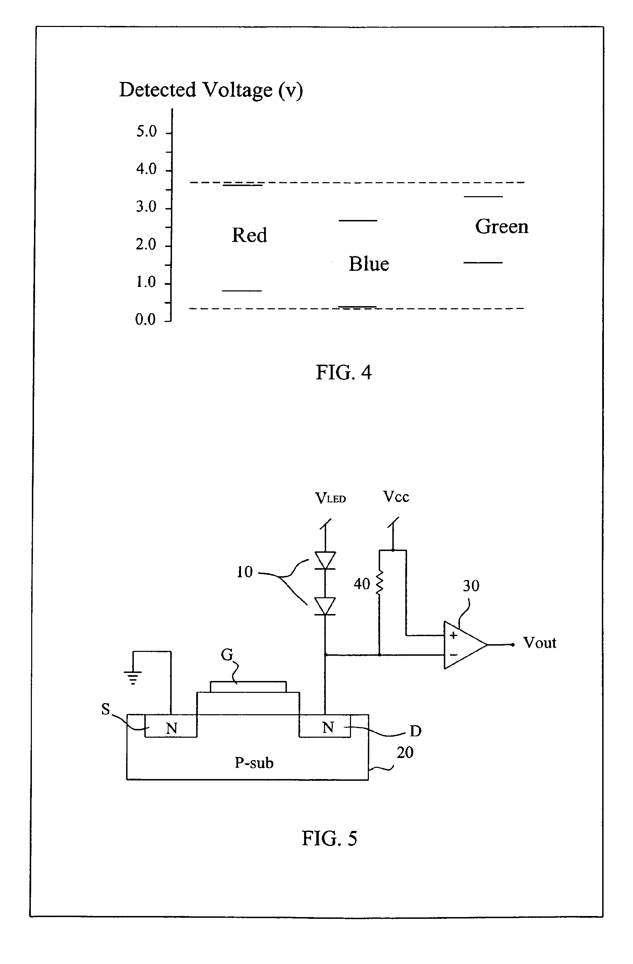

FIG. 4 shows the above reference voltages relatively, in which a range is marked with phantom lines.

According to relationship of $V_{LED}$ and $V_f$ in the circuit, voltage of the control output of the driver control circuit can be determined. By measuring voltage of the control output and comparing with the reference voltage, "normal", "short" or "open" states of the LED circuit can be detected in real time, no matter whether the LED is driven or not.

FIG. 5 shows another embodiment of the apparatus for silent current detection applied to LED. Different from FIG. 1, the negative electrode of the comparator (30) is further supplied with the reference voltage ($V_{CC}$) through a resistor (40), in addition to the control output of the driver control circuit. In this embodiment, the reference voltage is provided by the power source of the NMOS transistor (20). By comparing voltage of the positive electrode and the negative electrode of the comparator (30), "leakage current" of the driver control circuit can be detected. In the following equation, R is resistance of the resistor (40) and I is current flowing through the resistor (40). Let $(V_{CC}-R\times I)$ be higher than $(V_{LED}-n \times V_f)$, and the negative electrode of the comparator (30) will have voltage ($V_{IN-}$) as follows:

$$V_{IN-}=V_{CC}-(R\times I),$$

and the positive electrode of the comparator (30) will have voltage ($V_{IN+}$) as follows:

$$V_{IN+} = V_{CC}.$$

Accordingly, in this embodiment:

(1) if the NMOS transistor is normal, leakage current of the drain and the P-type substrate can be neglected (<1μA); then $V_{IN-} \approx V_{CC}$, ($V_{IN+}-V_{IN-}$)=0, and the comparator will output $V_{out}$ as "zero"; or
(2) if leakage current of the drain and the P-type substrate is obvious (>about 10μA); then $V_{IN-}=V_{CC}-(R1\times I)$, ($V_{IN+}-V_{IN-}$)>0, and the comparator will output $V_{out}$ as "High".

Similarly, by measuring voltage of the control output and comparing to the reference voltage with the comparator, "normal" or "leakage current" states of the driver circuit can be detected in real time, no matter whether the LED is driven or not.

It should be noticed that voltage of the control output of the driver control circuit can be measured with any other voltage-measuring devices, but not limited to the comparator.

It also should be noticed that the present invention is suitable for an application device not driven, and absolutely for an application device driven. If necessary, a current (usually less than 200μA for LEDs) may be supplied to the application device without influencing operation and viewing.

Furthermore, while LEDs are exemplified in the above preferred embodiments, leakage-current-detection of the present invention can be applied to any device driven by a driver control circuit, and short- or open-circuit-detection can be applied to any semiconductor device without departing from the scope of the present invention.

**Claims**

1. An apparatus for silent current detection, comprising:

an application device having a first contact and a second contact;
a voltage source connected to the first contact of the application device in a normal condition to providing a voltage;
a driver control circuit having a control output which is connected to the second contact of the application device in the normal condition to drive the application device; and
a voltage measuring device connected to the control output of the driver control circuit;
accordingly, states of the application device or the driver control circuit can be detected by measuring voltage of the control output, no matter whether the application device is driven or not.

2. The apparatus of claim 1, wherein the application device has an energy bandgap.

3. The apparatus of claim 2, wherein the application device comprises one or more LEDs in series which has a cathode contact defined as the first contact and an anode contact defined as the second contact.

4. The apparatus of claim 2, wherein the voltage measuring device comprises:

   a comparator having a positive electrode supplied with a reference voltage and a negative electrode connected to the control output of the driver control circuit;
   accordingly, open or short states of the application device can be detected by comparing voltages of the positive and negative electrodes of the comparator.

5. The apparatus of claim 1, wherein the voltage measuring device comprises:

   a comparator having a positive electrode supplied with a reference voltage and a negative electrode connected to the control output of the driver control circuit; and
   a resistor having one end supplied with the reference voltage and another end connected to the negative electrode of the comparator;
   accordingly, leakage current of the driver control circuit can be detected by comparing voltages of the positive and negative electrodes of the comparator.

6. The apparatus of claim 5, wherein the reference voltage is supplied by a power source of the driver control circuit.

7. The apparatus of claim 1, wherein the driver control circuit comprises an NMOS transistor having a drain defined as the control output.

8. The apparatus of claim 1, wherein the application device is driven with a current ranging $0.1 \sim 200 \mu A$.

9. A method for silent current detection, which detects states of an application device and a driver control circuit having a control output, comprising a step of :

   measuring voltage of the control output which drives the application device in a normal condition by connecting to a contact of the application device;
   accordingly, short, open or leakage current states of the application device and the driver control circuit can be detected, no matter whether the application device is driven or not.

10. A method for silent current detection, which detects states of an LED and a driver control circuit having a control output, comprising a step of:

    measuring voltage of the control output which drives the LED in a normal condition by connecting to a contact of the LED;
    accordingly, short, open or leakage current states of the LED and the driver control circuit can be detected, no matter whether the LED is driven or not.

$V_{LED}$

10

$V_{CC}$

30

+

$V_{out}$

−

G

S

N

N

D

P-sub

20

**FIG. 1**

N

**FIG. 2**

P-sub

$I_{ON}$

$\Delta I_{ON}$

$\Delta V_{LED}$

Vf

$V_{LED}$

**FIG. 3**

Detected Voltage (v)

5.0 —

4.0 —

— — — — — — — — — — — — — — — — — — —

3.0 —

——————                                   Green

—————

2.0 —

                         Blue

1.0 —

—————

0.0 —

— — — — — — — — — — — — — — — — — — —

Red

FIG. 4

V<sub>LED</sub>    Vcc

10

40

30

+

Vout

−

G

S

N    N    D

P-sub    20

FIG. 5

**European Patent Office**

**EUROPEAN SEARCH REPORT**

Application Number

EP 06 01 3961

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 61 077997 A (SHARP KK) 21 April 1986 (1986-04-21) * figure 1 * | 1-10 | INV. G01R31/26 |
| X | US 6 147 617 A (KIM CHUL YONG [KR]) 14 November 2000 (2000-11-14) * abstract * * column 3, line 5 - line 20 * * column 6, line 5 - line 10 * * figures 4A,4B * | 1-10 | |
| A | EP 1 338 899 A (PATLITE CORP [JP]) 27 August 2003 (2003-08-27) * abstract * * figure 3 * | 1,9 | |
| A | DE 101 31 824 A1 (HELLA KG HUECK & CO [DE]) 20 February 2003 (2003-02-20) * abstract * * figure 1 * | 1,9 | |

TECHNICAL FIELDS SEARCHED (IPC)

G01R
B60R

The present search report has been drawn up for all claims

| Place of search | Date of completion of the search | Examiner |
|---|---|---|
| Munich | 18 September 2007 | LOPEZ-CARRASCO, A |

EPO FORM 1503 03.82 (P04C01)

## ANNEX TO THE EUROPEAN SEARCH REPORT
## ON EUROPEAN PATENT APPLICATION NO.

EP 06 01 3961

This annex lists the patent family members relating to the patent documents cited in the above-mentioned European search report.
The members are as contained in the European Patent Office EDP file on
The European Patent Office is in no way liable for these particulars which are merely given for the purpose of information.

18-09-2007

| Patent document cited in search report | | Publication date | Patent family member(s) | | Publication date |
|---|---|---|---|---|---|
| JP 61077997 | A | 21-04-1986 | JP | 2048250 C | 25-04-1996 |
|  |  |  | JP | 7082585 B | 06-09-1995 |
| US 6147617 | A | 14-11-2000 | NONE | | |
| EP 1338899 | A | 27-08-2003 | JP | 2003249383 A | 05-09-2003 |
|  |  |  | US | 2003160703 A1 | 28-08-2003 |
| DE 10131824 | A1 | 20-02-2003 | NONE | | |

EPO FORM P0459

For more details about this annex : see Official Journal of the European Patent Office, No. 12/82